# EUROPEAN PATENT APPLICATION

(11) **EP 4 810 860 A1**
(43) Date of publication of application: **23.09.2026**
(21) Application number: 26164760.6
(22) Date of filing: 13.03.2026
(51) Int. Cl.: F24F 1/16, F24F 1/38, F24F 13/30, F24F 11/65, F24F 12/00

(54) **MOVABLE ECONOMIZER COIL**

(30) Priority: 18.03.2025 US 202519082831
(71) Applicant: UNIFLAIR S.P.A., 35026 Conselve (IT)
(72) Inventor: CASSON, Vanna, Chioggia (IT)
(74) Representative: Plasseraud IP

(57) **Abstract**

An outdoor cooling unit includes a condenser heat exchanger configured to pass a refrigerant in a refrigeration circuit, at least one economizer heat exchanger configured to pass a cooling fluid in a load-cooling circuit, and a controller configured to receive an input signal indicating an ambient temperature and send an output signal to rotate the at least one economizer heat exchanger in response to receiving the input signal.

## Description

### BACKGROUND

### 1. Field of the Invention

The present invention relates to cooling systems, and more particularly to cooling systems used with information technology (IT) equipment racks and enclosures to support data processing, networking and telecommunications equipment.

### 2. Discussion of Related Art

Cooling systems for removing heat in conditioned spaces, such as IT environments, use heat transport fluids, such as air, water, or refrigerant, to transport heat energy from indoors to outdoors. Many cooling systems rely on a refrigeration cycle as the primary means of cooling. Pumped and blown refrigerant systems provide isolation between the primary heat removal system and IT equipment.

In some embodiments, the space being cooled is a data center or IT environment. A data center may include one or more rooms or spaces that contain rows of equipment racks designed to house electronic equipment, such as data processing, networking, and telecommunications equipment. During operation, the electronic equipment generates heat that needs to be removed to ensure the continued performance, reliability, and useful life of the equipment components housed by the equipment racks. One or more embodiments of the systems disclosed herein are designed to efficiently remove heat produced by the electronic equipment within the data center.

### SUMMARY

One aspect of the present disclosure is directed to an outdoor cooling unit comprising a condenser heat exchanger configured to pass a refrigerant in a refrigeration circuit, at least one economizer heat exchanger configured to pass a cooling fluid in a load-cooling circuit, and a controller configured to receive an input signal indicating an ambient temperature and send an output signal to rotate the at least one economizer heat exchanger in response to receiving the input signal.

Embodiments of the outdoor cooling unit further may include the refrigeration circuit in which the refrigeration circuit includes a compressor in fluid communication with the condenser, an evaporator in fluid communication with the condenser and the compressor, and an expansion valve in fluid communication with the condenser and the evaporator. The load-cooling circuit may include a heat exchanger in fluid communication with the at least one economizer heat exchanger and a pump in fluid communication with the heat exchanger and the at least one economizer heat exchanger. The controller may be coupled to the compressor, the expansion valve and the pump to control a mode of operation of the outdoor cooling unit. The mode of operation may include a mechanical mode of operation, an economization mode of operation and a mixed mode of operation. The controller, when sending the output signal, may be configured to rotate the at least one economizer heat exchanger from a first position in which the condenser heat exchanger and the at least one economizer heat exchanger can be operated in a mechanical mode of operation to a second position in which the condenser heat exchanger and the at least one economizer heat exchanger can be operated in an economization mode of operation or a mixed mode of operation. The controller, when sending the output signal, may be configured to rotate the at least one economizer heat exchanger to a first position in response to the input signal indicating the ambient temperature is above a predetermined temperature and configured to rotate the at least one economizer heat exchanger to a second position in response to the input signal indicating the ambient temperature is below the predetermined temperature. The outdoor cooling unit further may include a linkage arm coupled to the at least one economizer heat exchanger and a piston configured to move the linkage arm and the at least one economizer heat exchanger between the first position and the second position. The piston may be configured to move from a retracted position in which the at least one economizer heat exchanger is in the first position to an extended position in which the at least one economizer heat exchanger is in the second position. The at least one economizer heat exchanger may include a first economizer heat exchanger and a second economizer heat exchanger. The controller further may be configured to rotate the first economizer heat exchanger and the second economizer heat exchanger. The controller may be coupled to a compressor, an expansion valve and a pump to control a mode of operation of the outdoor cooling unit. The mode of operation may include a mechanical mode of operation, an economization mode of operation and a mixed mode of operation. The controller may be configured to rotate each of the first economizer heat exchanger and the second economizer heat exchanger from a first position in which the condenser heat exchanger, the first economizer heat exchanger and the second economizer heat exchanger can be operated in a mechanical mode of operation to a second position in which the condenser heat exchanger and the economizer heat exchanger can be operated in an economization mode of operation or a mixed mode of operation. The condenser heat exchanger may be V-shaped.

Another aspect of the present disclosure is directed to a method of operating an outdoor cooling unit including a condenser heat exchanger configured to pass a refrigerant in a refrigeration circuit and an economizer heat exchanger configured to pass a cooling fluid in a load-cooling circuit. In one embodiment, the method comprises: detecting an ambient temperature; receiving an input signal indicating the ambient temperature; and sending an output signal to rotate the at least one economizer heat exchanger in response to receiving the input signal. The method may comprise : in the event the ambient temperature is above a predetermined temperature, rotating the economizer heat exchanger to a first position; and in the event the ambient temperature is below the predetermined temperature, rotating the economizer heat exchanger to a second position.

Embodiments of the method further may include, in the first position, operating the condenser heat exchanger and the economizer heat exchanger in a mechanical mode of operation, and, in the second position, operating the condenser heat exchanger and the economizer heat exchanger in an economization mode of operation or a mixed mode of operation. The economizer heat exchanger may be moved between a first position and a second position by a linkage arm coupled to the economizer heat exchanger and a piston configured to move the linkage arm and the economizer heat exchanger. The piston may be configured to move from a retracted position in which the economizer heat exchanger is in the first position to an extended position in which the economizer heat exchanger is in the second position.

Yet another aspect of the present disclosure is directed to a non-transitory computer-readable medium storing thereon sequences of computer-executable instructions for controlling an operation of an outdoor cooling unit, the sequences of computer-executable instructions including instructions that instruct at least one processor to detect an ambient temperature, receive an input signal indicating the ambient temperature, in the event the ambient temperature is above a predetermined temperature, send an output signal to rotate an economizer heat exchanger to a first position, and in the event the ambient temperature is below the predetermined temperature, send an output signal to rotate the economizer heat exchanger to a second position.

Embodiments of the non-transitory computer-readable medium further may include, in the first position, operating the condenser heat exchanger and the economizer heat exchanger in a mechanical mode of operation, and, in the second position, operating the condenser heat exchanger and the economizer heat exchanger in an economization mode of operation or a mixed mode of operation. The economizer heat exchanger may be moved between the first position and the second position by a linkage arm coupled to the economizer heat exchanger and a piston configured to move the linkage arm and the economizer heat exchanger. The piston may be configured to move from a retracted position in which the economizer heat exchanger is in the first position to an extended position in which the economizer heat exchanger is in the second position.

Another aspect of the present disclosure is directed to an outdoor cooling unit comprising a condenser heat exchanger configured to pass a refrigerant in a refrigeration circuit, a first economizer heat exchanger configured to pass a cooling fluid in a load-cooling circuit, a second economizer heat exchanger configured to pass the cooling fluid in the load-cooling circuit, and a controller configured to receive an input signal indicating an ambient temperature and, in response to receiving the input signal, send a first output signal to rotate the first economizer heat exchanger and send a second output signal to rotate the second economizer heat exchanger.

Embodiments of the outdoor cooling unit further may include the refrigeration circuit in which the refrigeration circuit includes a compressor in fluid communication with the condenser, an evaporator in fluid communication with the condenser and the compressor, and an expansion valve in fluid communication with the condenser and the evaporator. The outdoor cooling unit further may include the load-cooling circuit. The load-cooling circuit may include a heat exchanger in fluid communication with the first economizer heat exchanger and the second economizer heat exchanger and a pump in fluid communication with the heat exchanger and the first economizer heat exchanger and the second economizer heat exchanger. The controller may be coupled to the compressor, the expansion valve and the pump to control a mode of operation of the outdoor cooling unit. The mode of operation may include a mechanical mode of operation, an economization mode of operation and a mixed mode of operation. The controller, when sending the output signal, may be configured to rotate each of the first economizer heat exchanger and the second economizer heat exchanger from a first position in which the condenser heat exchanger, the first economizer heat exchanger and the second economizer heat exchanger can be operated in a mechanical mode of operation to a second position in which the condenser heat exchanger and the economizer heat exchanger can be operated in an economization mode of operation or a mixed mode of operation. The controller, when sending the output signal, may be configured to rotate the first economizer heat exchanger to a first position and to rotate the second economizer heat exchanger to the first position in response to the input signal indicating the ambient temperature is above a predetermined temperature and configured to rotate the first economizer heat exchanger to the second position and to rotate the second economizer heat exchanger to the second position in response to the input signal indicating the ambient temperature is below a predetermined temperature. The outdoor cooling unit further may include a first linkage arm coupled to the first economizer heat exchanger and a first piston configured to move the first linkage arm and the first economizer heat exchanger between the first position and the second position, and a second linkage arm coupled to the second economizer heat exchanger and a second piston configured to move the second linkage arm and the second economizer heat exchanger between the first position and the second position. The first piston may be configured to move from a retracted position in which the first economizer heat exchanger is in the first position to an extended position in which the first economizer heat exchanger is in the second position. The second piston may be configured to move from a retracted position in which the second economizer heat exchanger is in the first position to an extended position in which the second economizer heat exchanger is in the second position.

### BRIEF DESCRIPTION OF THE DRAWINGS

For a better understanding of the present invention, reference is made to the figures which are incorporated herein by reference and in which:
FIG. 1 is a schematic view of a cooling unit of an embodiment of the present disclosure;
FIG. 2 is a schematic side view of the cooling unit in an economization and mixed modes of operation;
FIG. 3 is a schematic side view of the cooling unit in a mechanical mode of operation;
FIG. 4 is a perspective view of a cooling unit of another embodiment of the present disclosure.
FIG. 5 is a side view of the cooling unit in the economization and mixed modes of operation;
FIG. 6 is a side view of the cooling unit showing movement of an economization coil with respect to a condenser coil;
FIG. 7 is a side view of the cooling unit in the mechanical mode of operation; and
FIG. 8 is a diagram of a method of operating a cooling unit of an embodiment of the present disclosure.

### DETAILED DESCRIPTION

The present disclosure is directed to a cooling system including an outdoor cooling unit having a condenser coil and an economizer coil that passes refrigerant and a cooling fluid, respectively, in a refrigeration circuit and a load-cooling circuit, respectively. A controller receives a signal indicating that an ambient temperature is above a threshold and causes the economizer coil to rotate further from the condenser coil.

The reduction of air side pressure drops can be obtained by increasing the fin pitch of the coils, but this solution may contrast with the need to have an adequate external coil surface to reach the proper capacity, and consequently it is not a practicable unless the front surface of the coil is increased excessively. The power absorbed by the fan(s) affects the efficiency of the unit, i.e., the more power used by the fan(s) decreases efficiency. The condensing temperature is related to the air mass flow rate passing through the condenser. To reduce the condensing temperature (decreasing the compressors power input, and increasing the unit efficiency), it may be necessary to increase the mass flow rate and consequently the pressure drops. In this way the fan input power increases as well. A compromise between high air mass flow rate, low condensing temperature, and higher fan(s) input power is desired. An increase of the air mass flow rate (power input of fan(s)) may result in a higher maximum ambient temperature of the unit. As is also known, a higher fan(s) speed results in higher unit noise level in addition to increased energy usage.

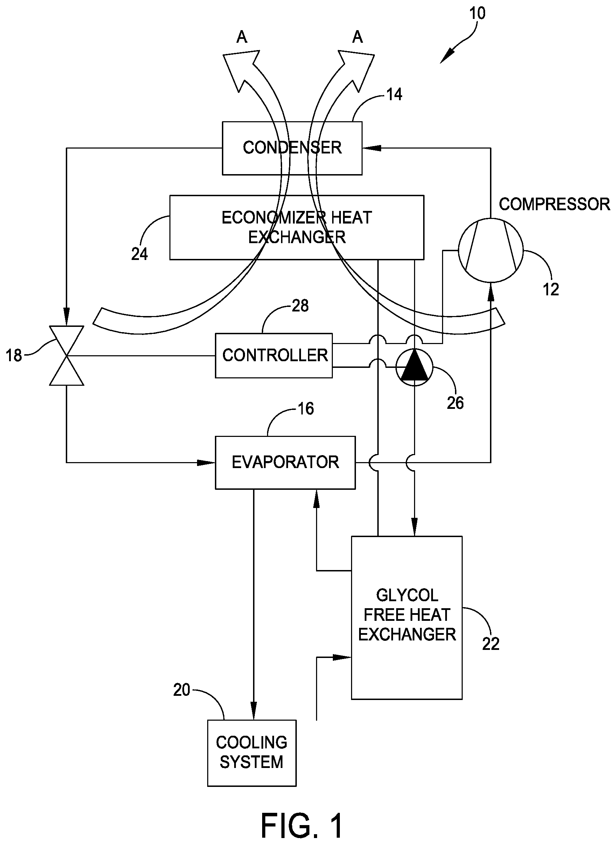

Referring to the drawings, and more particularly to FIG. 1, a cooling unit is generally indicated at 10. The cooling unit 10, which sometimes may be referred to as an outdoor cooling unit, includes a refrigeration circuit embodying a vapor-compression cycle. The refrigeration circuit includes two heat exchangers, a condenser, also referred to as a condenser heat exchanger, configured to release heat, and an evaporator configured to accept heat. At a start of the vapor-compression cycle, a low pressure refrigerant enters a compressor, which is configured to increase the pressure to cause the refrigerant to leave the compressor as a higher temperature and higher pressure superheated gas. The pressurized gas then passes through the condenser where the gas releases heat to the surroundings as it cools and condenses. The cooler refrigerant passes through an expansion valve, which is configured to reduce the pressure and cause a temperature of the refrigerant to drop. The cold low-pressure refrigerant is directed to the evaporator, which is configured to vaporize the refrigerant as it receives heat from the surroundings before returning to the compressor as a low temperature fluid or gas.

As shown, the cooling unit 10 includes a compressor 12 in fluid communication with a condenser 14. The compressor 12 may embody any type of compressor, e.g., a scroll-, a screw- or a centrifugal-type compressor, suitable for pressurizing fluids. In one embodiment, the compressor 12 receives low pressure refrigerant gas and pressurizes the refrigerant gas to increase the temperature and pressure. The superheated pressurized gas then passes through the condenser 14 where the gas releases heat to the surroundings as it cools and condenses. As noted above, the condenser 14 is a heat exchanger that is provided to condense a gas into a liquid through cooling. Heat is released and transferred to the surrounding environment.

The condenser 14 is in fluid communication with an evaporator 16 in which the cooler refrigerant first passes through an expansion valve 18. As noted above, the expansion valve 18 is configured to reduce the pressure and cause a temperature to drop of the fluid refrigerant received from the condenser 14. The cold low pressure refrigerant is directed to the evaporator 16, which may be a finned coil, a plate, a shell or a tube, and is configured to exchange the heat during operation. The evaporator 16 is configured to output a liquid, e.g., the liquid refrigerant or coolant, at a temperature, with the evaporator 16 being coupled to a cooling system, indicated at 20, requiring cooling fluid at the temperature. For example, the evaporator 16 of the cooling unit 10 may be configured to cool refrigerant for use in a liquid cooling system, e.g., cooling system 20, to provide cooling to electronic equipment supported by IT equipment racks. The entire flow of refrigerant within the refrigeration circuit is compressed by the compressor 12, after that condensed by the condenser 14 and then is expanded through the expansion valve 18, which modulates the flow quantity based on the request of cooling capacity of evaporator 16.

The cooling unit 10 further may include a heat exchanger, in particular a glycol-free heat exchanger 22, that is in fluid communication with an economizer heat exchanger 24 to provide an economization mode of operation for the cooling unit 10. This mode of operation is sometimes referred to as "free cooling." As shown, the cooling unit 10 further includes a pump 26, which is provided to facilitate the flow of glycol-free coolant between the glycol-free heat exchanger 22 and the economizer heat exchanger 24. The economizer heat exchanger 24 is proximate to the condenser 14, and as noted above, can impact airflow through the condenser 14 when in a mechanical mode of operation. The ability to cool a fluid by taking advantage of the low ambient temperature is widely known and applied. In particular, when cooling liquid substances, e.g., refrigerants, suitable finned coil heat exchangers may be used, to avoid having to switch on the compressor 12 of the refrigeration circuit. The pump 26 for the circulation of this fluid, if liquid (or a fan if gaseous), and one or more fans for moving the external air, are sufficient to obtain a desired cooling effect. It is possible to cool down with this method any kind of fluid. As noted, this mode of operation is sometimes referred to as the economization mode of operation.

As the ambient temperature increases, the cooling capacity achieved by utilizing the economization mode is no longer sufficient. During this temperature increase, the cooling unit 10 is configured to obtain the maximum capacity of the economizer heat exchanger 24, and then to integrate the missing part by operating the compressor 12 of the cooling unit 10. This working mode of operation is sometimes referred to as partial economization mode or mix mode of operation. As the ambient temperature further increases, at a certain point it is difficult to achieve an economization capacity. The total requested cooling capacity may be produced by the compressor 12, and the working mode is sometimes referred to as a mechanical mode of operation.

As noted above, the economizer heat exchanger 24 may be in fluid communication with a glycol-free heat exchanger 22. On one side of the economizer heat exchanger 24, there is a mixture of glycol and water, which will then be sent to the glycol-free heat exchanger 22, which can be placed outdoors. On the other side of the economizer heat exchanger 24, there is a glycol-free liquid, e.g., pure water, which is also sent to the glycol-free heat exchanger 22. This allows simpler management of the user-side fluid, as the absence of glycol makes it possible to avoid periodic maintenance and improves the heat exchanger characteristics and therefore efficiency. On the other hand, the presence of the economizer heat exchanger 24 causes the operation in economization mode to be less than optimal because on the glycol water side of the economizer heat exchanger 24, the temperatures of the fluid are lower and consequently the number of hours per year in which the total economization mode can work decreases.

The cooling unit 10 further includes one or more fans, which cause airflow through the cooling unit, which is represented by arrows A. One aspect to consider is related to the regulation of the fans. It may be desired to maintain the fans at a minimum speed necessary to be able to obtain the required cooling capacity or, vice versa, to be able to reduce the air pressure drops through the economizer heat exchanger 24 and the condenser 14 in order to reduce the number of fan revolutions and consequently the absorbed power. In instances in which the economizer heat exchanger 24 is large and there are many fans, the electrical power absorbed by the fans for the movement of the external air through the economizer heat exchanger 24 and the condenser 14 can exceed, in some working conditions, the power absorbed by the compressor 12 running at a minimum, which is not negligible.

The cooling unit 10 further includes a controller, indicated at 28, which is connected to the compressor 12, the expansion valve 18 and the pump 26 to control the mode of operation of the cooling unit. The controller 28 may be coupled to other components of the cooling unit, such as the condenser 14 and the evaporator 16, to monitor the operation of these components. As noted above, the modes of operation include the mechanical mode of operation, the economization mode of operation and the mixed mode of operation.

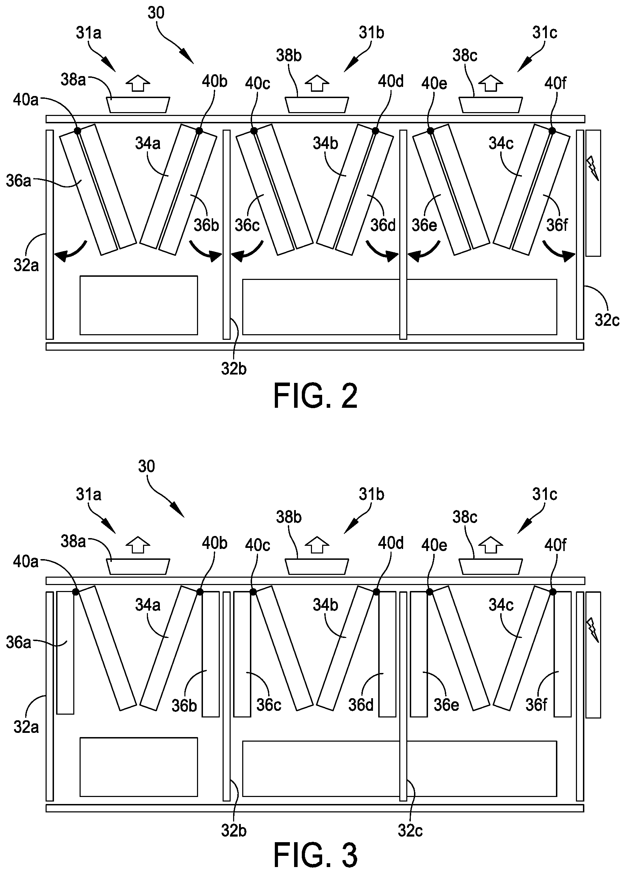

Referring to FIGS. 2 and 3, one embodiment of the present disclosure is directed to moving the economizer heat exchanger 24 away from the airflow when not in operation, i.e., when the operating mode is the mechanical mode of operation. As shown, a cooling unit, generally indicated at 30, include multiple condensing units, each generally indicated at 31a, 31b, 31c, respectively. Although three condenser units 31a, 31b, 31c are shown, it should be understood that the principles disclosed herein can apply to a single cooling unit or to multiple cooling units.

In one embodiment, each condenser unit 31a, 31b, 31c is substantially similar to the condenser 14 of cooling unit 10 shown in FIG. 1. As shown, the condenser unit 31a includes a housing 32a, which is configured to support a V-shaped condenser 34a and two economizer heat exchangers 36a, 36b. Similarly, the condenser unit 31b includes a housing 32b, which is configured to support another V-shaped condenser 34b and two economizer heat exchangers 36c, 36d, and the condenser unit 31c includes a housing 32c, which is configured to support another V-shaped condenser 34c and two economizer heat exchanger 36e, 36f. Each condenser unit 31a, 31b, 31c further includes a fan unit 38a, 38b, 38c, configured to draw air through their respective condenser units 31a, 31b, 31c. The cooling unit 30 may include other components, such as compressors, evaporators, expansion valves and controllers, which are configured to operate the cooling unit 10.

FIG. 2 illustrates the economizer heat exchangers 36a, 36b, 36c, 36d, 36e, 36f positioned proximate to their respective condensers 34a, 34b, 34c. In this position, the condenser units 31a, 31b, 31c are configured to operate in the economization mode of operation or the mixed mode of operation. FIG. 3 illustrates the economizer heat exchangers 36a, 36b, 36c, 36d, 36e, 36f rotated or swung away from their respective condensers 34a, 34b, 34c so that the economizer heat exchangers 36a, 36b, 36c, 36d, 36e, 36f are proximate to their respective housings 32a, 32b, 32c of the condenser units 31a, 31b, 31c. In this position, the condenser units 31a, 31b, 31c of the cooling unit 30 are configured to operate in the mechanical mode of operation.

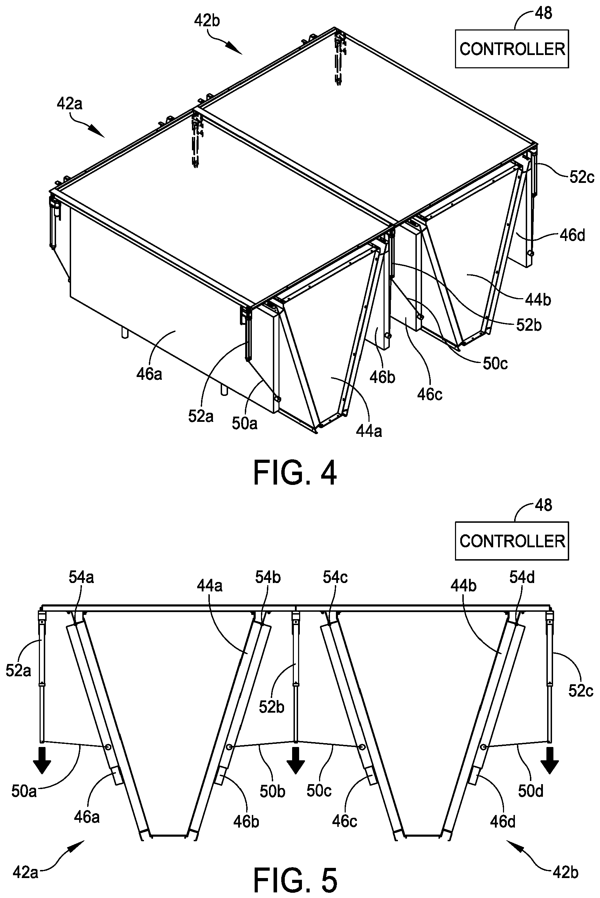

As will be described in greater detail below with respect to FIGS. 4-7, when the economizer heat exchangers 36a, 36b, 36c, 36d, 36e, 36f are in the economization mode of operation or the mixed mode of operation, airflow through the condenser units 31a, 31b, 31c flows through both the economizer heat exchangers 36a, 36b, 36c, 36d, 36e, 36f, and the condensers 34a, 34b, 34c. As noted above, airflow is somewhat restricted by the presence of the economizer heat exchangers 36a, 36b, 36c, 36d, 36e, 36f. When the mechanical mode of operation is desired, the economizer heat exchangers 36a, 36b, 36c, 36d, 36e, 36f move from the economizer or mixed mode shown in FIG. 2 and are rotated about respective linchpins 40a, 40b, 40c, 40d, 40e, 40f, as shown, to the mechanical mode shown in FIG. 3, consequently reducing the air side pressure drops within the condenser units 31a, 31b, 31c. With each condenser unit 31a, 31b, 31c, air flows through only one heat exchanger, e.g., condensers 34a, 34b, 34c, respectively, instead of two heat exchangers. The reduction of the power absorbed by the fan units 38a, 38b, 38c with a consequent increase in the efficiency of the condenser units 31a, 31b, 31c, under the same conditions, in mechanical mode. The increase of the air flow rate passing through the condensers 34a, 34b, 34c, with the consequent possibility of reducing the condensing temperature for a given ambient temperature, and increasing the efficiency of the cooling unit 30.

Referring to FIGS. 4-7, a first condenser unit is generally indicated at 42a and a second cooling unit is generally indicated at 42b. As shown, the first cooling unit 42a includes a first V-shaped condenser heat exchanger 44a. The first condenser unit 42a further includes a first economizer heat exchanger 46a and a second economizer heat exchanger 46b. The components of the first condenser unit 42a are supported by a housing, which is not shown to better illustrate the first condenser heat exchanger 44a, the first economizer heat exchanger 46a and the second economizer heat exchanger 46b.

Similarly, the second condenser unit 42b includes a second V-shaped condenser heat exchanger 44b. The second condenser unit 42b further includes a third economizer heat exchanger 46c and a fourth economizer heat exchanger 46d. The components of the second condenser unit 42b are supported by a housing, which is not shown to better illustrate the second condenser heat exchanger 44b, the third economizer heat exchanger 46c and the fourth economizer heat exchanger 46d.

The condenser units 42a, 42b are configured similarly if not identically to the condenser units 31a, 31b, 31c of cooling unit 30.

The cooling unit embodying condenser units 42a, 42b further includes a controller 48, which is configured to control the operation of a compressor, an expansion valve and a pump of the cooling unit and to control the mode of operation of the condenser unit 42a, 42b. As noted, the mode of operation includes a mechanical mode of operation, an economization mode of operation and a mixed mode of operation. The controller 48 further is connected to rotation mechanisms associated with the first economizer heat exchanger 46a, the second and third economizer heat exchangers 46b, 46c, and the fourth economizer heat exchanger 46d. The controller 48, via the rotation mechanisms, is configured to rotate each of the first economizer heat exchanger 46a, the second economizer heat exchanger 46b, the third economizer heat exchanger 46c, and the fourth economizer heat exchanger 46d from a first position in which the condenser units 42a, 42b can operate in the economization mode of operation or the mixed mode of operation to a second position. In the first position, the first economizer heat exchanger 46a and the second economizer heat exchanger 46b are proximate to the first condenser heat exchanger 44a and the third economizer heat exchanger 46c and the fourth economizer heat exchanger 46d are proximate to the second condenser heat exchanger 44b. In the second position, the first economizer heat exchanger 46a and the second economizer heat exchanger 46b are rotated away and spaced from the first condenser heat exchanger 44a and the third economizer heat exchanger 46c and the fourth economizer heat exchanger 46d are rotated away and spaced from the second condenser heat exchanger 44b.

With particular reference to FIGS. 5-7, the condenser units 42a, 42b further include a first linkage arm 50a connected to the first economizer heat exchanger 46a, a second linkage arm 50b connected to the second economizer heat exchanger 46b, a third linkage arm 50c connected to the third economizer heat exchanger 46c, and a fourth linkage arm 50d connected to the fourth economizer heat exchanger 46d. The cooling units 42a, 42b further include a first piston 52a connected to the first linkage arm 50a, a second piston 52b connected to the second linkage arm 50b and the third linkage arm 50c, and a third piston 52c connected to the fourth linkage arm 50d. As shown, the first economizer heat exchanger 46a, the second economizer heat exchanger 46b, the third economizer heat exchanger 46c, and the fourth economizer heat exchanger 46d are pivotally connected to either the top ends of the condenser heat exchangers 44a, 44b or the housing of the condenser units 42a, 42b by linchpins 54a, 54b, 54c, 54d, respectively.

As shown in FIG. 4, the number of linkage arms 50a, 50b, 50c, 50d and the number of pistons 52a, 52b, 52c may be doubled, with one set of linkage arms 50a, 50b, 50c, 50d and one set of pistons 52a, 52b, 52c being provided on one side of the condenser units 42a, 42b and another set of linkage arms 50a, 50b, 50c, 50d and another set of pistons 52a, 52b, 52c being provided on the opposite side of the condenser units 42a, 42b. For clarity, only one set of linkage arms 50a, 50b, 50c, 50d and one set of pistons 52a, 52b, 52c are referenced in FIG. 4.

FIG. 5 illustrates the pistons 52a, 52b, 52c, in extended positions, which results in the first economizer heat exchanger 46a, the second economizer heat exchanger 46b, the third economizer heat exchanger 46c, and the fourth economizer heat exchanger 46d in their respective first positions in which the cooling unit can be operated in the economization mode of operation or the mixed mode of operation. As shown, the first linkage arm 50a, the second linkage arm 50b, the third linkage arm 50c, and the fourth linkage arm 50d each extend generally perpendicularly from their respective piston 52a, 52b, 52c to position the first economizer heat exchanger 46a, the second economizer heat exchanger 46b, the third economizer heat exchanger 46c, and the fourth economizer heat exchanger 46d proximate to their respective first condenser heat exchanger 44a and second condenser heat exchanger 44b.

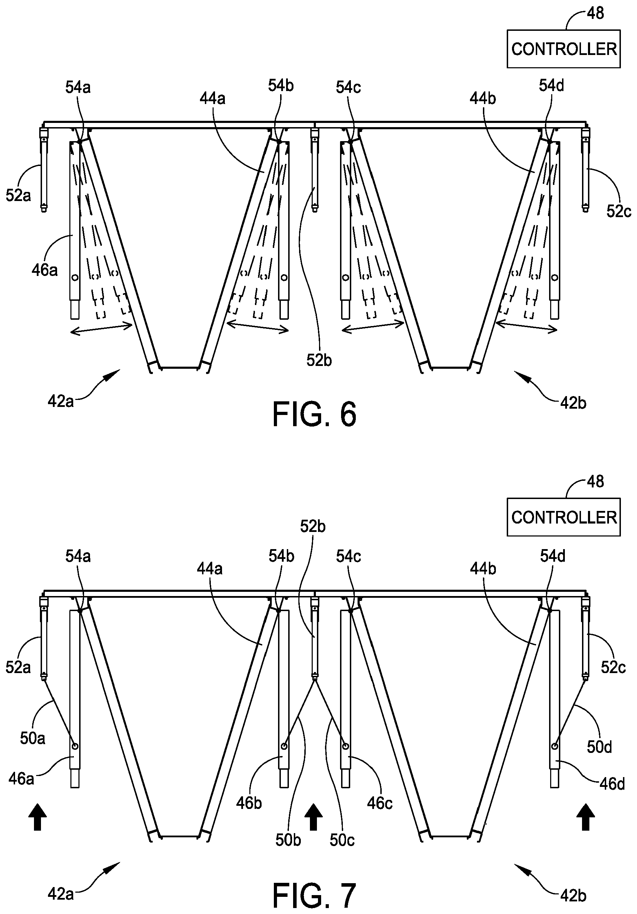

FIG. 6 shows the movements of the first economizer heat exchanger 46a, the second economizer heat exchanger 46b, the third economizer heat exchanger 46c, and the fourth economizer heat exchanger 46d from their respective second positions to their respective first positions. The movement of the first economizer heat exchanger 46a, the second economizer heat exchanger 46b, the third economizer heat exchanger 46c, and the fourth economizer heat exchanger 46d is shown by dashed lines, with the linkage arms 50a, 50b, 50c, 50d removed.

FIG. 7 illustrates the pistons 52a, 52b, 52c, 52d in retracted positions, which results in the first economizer heat exchanger 46a, the second economizer heat exchanger 46b, the third economizer heat exchanger 46c, and the fourth economizer heat exchanger 46d in their respective second positions in which the cooling unit can be operated in the mechanical mode of operation. As shown, the first linkage arm 50a, the second linkage arm 50b, the third linkage arm 50c, and the fourth linkage arm 50d each extend generally downwardly from their respective piston 52a, 52b, 52c to position the first economizer heat exchanger 46a, the second economizer heat exchanger 46b, the third economizer heat exchanger 46c, and the fourth economizer heat exchanger 46d in generally vertical positions away from their respective first condenser heat exchanger 44a and second condenser heat exchanger 44b.

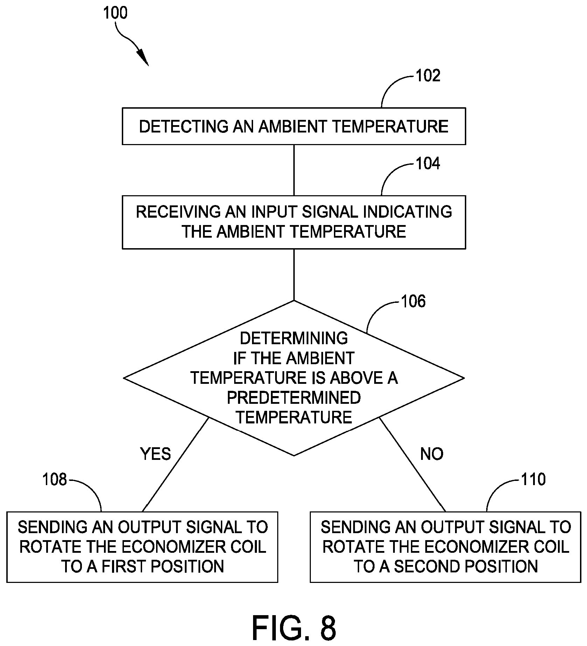

Referring to FIG. 8, a method of operating the cooling unit is generally indicated at 100. At step 102, the method 100 includes detecting an ambient temperature of the cooling unit. In one embodiment, detecting ambient temperature can be achieved by a temperature sensor coupled to the controller. At step 104, the method 100 further includes receiving an input signal indicating the ambient temperature. The input signal may be sent by the temperature sensor to the controller. At decision 106, the method 100 further includes determining if the ambient temperature is above a predetermined temperature. At step 108, in the event the ambient temperature is above a predetermined temperature, the method 100 further includes sending an output signal to rotate the economizer heat exchanger to a first position. In this position, the piston is extended to move the economizer heat exchanger away from the condenser heat exchanger to enable the cooling unit to operate in the mechanical mode of operation. At step 110, in the event the ambient temperature is below the predetermined temperature, the method 100 further includes sending an output signal to rotate the economizer heat exchanger to a second position. In this position, the piston is retracted to move the economizer heat exchanger toward and proximate to the condenser heat exchanger to enable the cooling unit to operate in the economization mode of operation or the mixed mode of operation.

In some embodiments, if the economizer heat exchanger changes its position, the economizer heat exchanger may be connected to flexible pipes. The choice of the economizer heat exchanger height deserves consideration. If the height of the finned pack is kept the same as that of the condenser heat exchanger, when the condenser heat exchanger is moved to the vertical position during mechanical operation, a suitable support can be provided.

In some embodiments, due to dimensions and positions of other components of the cooling unit, it may be necessary to reduce a height of a battery. In this case, when the economizer heat exchanger comes into operation, and is placed in the position next to the condenser heat exchanger, it would have a lower finned pack. To avoid air bypass phenomena, in this case a suitable movable plate can be provided which is positioned in front of the lower part of the condenser heat exchanger to avoid the by-pass during operation in total economization mode. However, when the mixed operation begins, it is foreseen a convenience in the removal of this plate to favor a possible greater subcooling of the refrigerant at the outlet of the condenser heat exchanger and therefore an improvement in the efficiency of the refrigerating cycle.

In some embodiments, an outdoor cooling unit with a condenser coil and an economizer heat exchanger that pass refrigerant and a cooling fluid, respectively, in a refrigeration circuit and load-cooling circuit, respectively. A controller receives a signal indicating an ambient temperature above a threshold and causes the economizer heat exchanger to rotate further from the condenser coil.

Embodiments of the cooling unit make it possible to move the economizer heat exchanger away from the air flux when not in operation. This causes more airflow through the condenser coil when the ambient temperature is above a threshold temperature, thereby resulting in higher unit efficiency, lower condensing temperature in mechanical mode, higher maximum ambient temperature and lower noise of the unit.

Embodiments of the cooling unit further reduces the power absorbed by fans with a consequent increase in the efficiency of the cooling unit, under the same conditions, in mechanical mode. The increase of the air flow rate passing through the condenser, with the consequences of potentially reducing the condensing temperature for a given ambient temperature and increasing the efficiency of the cooling unit.

Various controllers may execute various operations discussed above, including operations performed by controllers 28, 48. Using data stored in associated memory and/or storage, the controller also executes one or more instructions stored on one or more non-transitory computer-readable media, which the controller may include and/or be coupled to, that may result in manipulated data. In some examples, the controller may include one or more processors or other types of controllers. In one example, the controller is or includes at least one processor. In another example, the controller performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

For the purposes of illustration only, and not to limit the generality, the present invention will now be described in detail with reference to the accompanying figures. This invention is not limited in its application to the details of construction and the arrangement of components set forth in the following description or illustrated in the drawings. The invention is capable of other embodiments and of being practiced or being carried out in various ways. Also, the phraseology and terminology used herein is for the purpose of description and should not be regarded as limiting. The use of "including," "comprising," "having," "containing" "involving," and variations thereof herein, is meant to encompass the items listed thereafter and equivalents thereof as well as additional items.

Having thus described at least one embodiment of the present invention, various alternations, modifications and improvements will readily occur to those skilled in the art. Such alterations, modifications and improvements are intended to be within the scope and spirit of the invention. Accordingly, the foregoing description is by way of example only and is not intended to be limiting. The invention's limit is defined only in the following claims and equivalents thereto.

Below are provided a number of examples.

According to an example, an outdoor cooling unit is provided, the outdoor cooling unit comprising:
a condenser heat exchanger configured to pass a refrigerant in a refrigeration circuit;
at least one economizer heat exchanger configured to pass a cooling fluid in a load-cooling circuit; and
a controller configured to receive an input signal indicating an ambient temperature and send an output signal to rotate the at least one economizer heat exchanger in response to receiving the input signal.

According to an example, the outdoor cooling unit further comprising the refrigeration circuit, wherein the refrigeration circuit includes
a compressor in fluid communication with the condenser,
an evaporator in fluid communication with the condenser and the compressor, and
an expansion valve in fluid communication with the condenser and the evaporator.

According to an example, the outdoor cooling unit wherein the load-cooling circuit includes
a heat exchanger in fluid communication with the at least one economizer heat exchanger, and
a pump in fluid communication with the heat exchanger and the at least one economizer heat exchanger.

According to an example, the outdoor cooling unit wherein the controller is coupled to the compressor, the expansion valve and the pump to control a mode of operation of the outdoor cooling unit.

According to an example, the outdoor cooling unit wherein the mode of operation includes a mechanical mode of operation, an economization mode of operation and a mixed mode of operation.

According to an example, the outdoor cooling unit wherein the controller, when sending the output signal, is configured to rotate the at least one economizer heat exchanger from a first position in which the condenser heat exchanger and the at least one economizer heat exchanger can be operated in a mechanical mode of operation to a second position in which the condenser heat exchanger and the at least one economizer heat exchanger can be operated in an economization mode of operation or a mixed mode of operation.

According to an example, the outdoor cooling unit wherein the controller, when sending the output signal, is configured to rotate the at least one economizer heat exchanger to a first position in response to the input signal indicating the ambient temperature is above a predetermined temperature and configured to rotate the at least one economizer heat exchanger to a second position in response to the input signal indicating the ambient temperature is below the predetermined temperature.

According to an example, the outdoor cooling unit further comprising a linkage arm coupled to the at least one economizer heat exchanger and a piston configured to move the linkage arm and the at least one economizer heat exchanger between the first position and the second position.

According to an example, the outdoor cooling unit wherein the piston is configured to move from a retracted position in which the at least one economizer heat exchanger is in the first position to an extended position in which the at least one economizer heat exchanger is in the second position.

According to an example, the outdoor cooling unit wherein the at least one economizer heat exchanger includes a first economizer heat exchanger and a second economizer heat exchanger, and wherein the controller further is configured to rotate the first economizer heat exchanger and the second economizer heat exchanger.

According to an example, the outdoor cooling unit wherein the controller is coupled to a compressor, an expansion valve and a pump to control a mode of operation of the outdoor cooling unit.

According to an example, the outdoor cooling unit wherein the mode of operation includes a mechanical mode of operation, an economization mode of operation and a mixed mode of operation.

According to an example, the outdoor cooling unit wherein the controller is configured to rotate each of the first economizer heat exchanger and the second economizer heat exchanger from a first position in which the condenser heat exchanger, the first economizer heat exchanger and the second economizer heat exchanger can be operated in a mechanical mode of operation to a second position in which the condenser heat exchanger and the economizer heat exchanger can be operated in an economization mode of operation or a mixed mode of operation.

According to an example, it is provided a method of operating an outdoor cooling unit including a condenser heat exchanger configured to pass a refrigerant in a refrigeration circuit and an economizer heat exchanger configured to pass a cooling fluid in a load-cooling circuit, the method comprising:
detecting an ambient temperature;
receiving an input signal indicating the ambient temperature;
in the event the ambient temperature is above a predetermined temperature, rotating the economizer heat exchanger to a first position; and
in the event the ambient temperature is below the predetermined temperature, rotating the economizer heat exchanger to a second position.

According to an example, the method wherein in the first position, the condenser heat exchanger and the economizer heat exchanger can be operated in a mechanical mode of operation, and wherein in the second position, the condenser heat exchanger and the economizer heat exchanger can be operated in an economization mode of operation or a mixed mode of operation.

According to an example, the method wherein the economizer heat exchanger is moved between a first position and a second position by a linkage arm coupled to the economizer heat exchanger and a piston configured to move the linkage arm and the economizer heat exchanger.

According to an example, the method of wherein the piston is configured to move from a retracted position in which the economizer heat exchanger is in the first position to an extended position in which the economizer heat exchanger is in the second position.

According to an example, it is provided a non-transitory computer-readable medium storing thereon sequences of computer-executable instructions for controlling an operation of an outdoor cooling unit, the sequences of computer-executable instructions including instructions that instruct at least one processor to:
detect an ambient temperature;
receive an input signal indicating the ambient temperature;
in the event the ambient temperature is above a predetermined temperature, send an output signal to rotate an economizer heat exchanger to a first position; and
in the event the ambient temperature is below the predetermined temperature, send an output signal to rotate the economizer heat exchanger to a second position.

According to an example, the non-transitory computer-readable medium wherein in the first position, the condenser heat exchanger and the economizer heat exchanger can be operated in a mechanical mode of operation, and wherein in the second position, the condenser heat exchanger and the economizer heat exchanger can be operated in an economization mode of operation or a mixed mode of operation.

According to an example, the non-transitory computer-readable medium wherein the economizer heat exchanger is moved between the first position and the second position by a linkage arm coupled to the economizer heat exchanger and a piston configured to move the linkage arm and the economizer heat exchanger.

According to an example, the non-transitory computer-readable medium wherein the piston is configured to move from a retracted position in which the economizer heat exchanger is in the first position to an extended position in which the economizer heat exchanger is in the second position.

## Claims

1. An outdoor cooling unit (10, 30), comprising:
a condenser heat exchanger (14, 34a, 34b, 34c, 44a, 44b) configured to pass a refrigerant in a refrigeration circuit;
at least one economizer heat exchanger (24, 36a, 36b, 36c, 36d, 36e, 36f, 46a, 46b, 46c, 46d) configured to pass a cooling fluid in a load-cooling circuit; and
a controller (28, 48) configured to receive an input signal indicating an ambient temperature and send an output signal to rotate the at least one economizer heat exchanger (24, 36a, 36b, 36c, 36d, 36e, 36f, 46a, 46b, 46c, 46d) in response to receiving the input signal.

2. The outdoor cooling unit of claim 1, wherein the controller (28, 48) is configured to control a mode of operation of the outdoor cooling unit (10, 30), the mode of operation including a mechanical mode of operation, an economization mode of operation and a mixed mode of operation.

3. The outdoor cooling unit of claim 2, wherein the controller (28, 48) is coupled to a compressor (12), an expansion valve (18) and a pump (26) to control the mode of operation of the outdoor cooling unit (10, 30).

4. The outdoor cooling unit of claim 3, further comprising the refrigeration circuit, wherein the refrigeration circuit includes
the compressor (12) in fluid communication with the condenser heat exchanger (14),
an evaporator (16) in fluid communication with the condenser heat exchanger (14) and the compressor (12), and
the expansion valve (18) in fluid communication with the condenser heat exchanger (14) and the evaporator (16).

5. The outdoor cooling unit of any of the claims 3 or 4, wherein the load-cooling circuit includes
a heat exchanger (22) in fluid communication with the at least one economizer heat exchanger (24), and
the pump (26) in fluid communication with the heat exchanger (22) and the at least one economizer heat exchanger (24).

6. The outdoor cooling unit of any one of the claims 2 to 5, wherein the controller (28, 48), when sending the output signal, is configured to rotate the at least one economizer heat exchanger (24, 36a, 36b, 36c, 36d, 36e, 36f, 46a, 46b, 46c, 46d) from a first position in which the condenser heat exchanger (14, 34a, 34b, 34c, 44a, 44b) and the at least one economizer heat exchanger (24, 36a, 36b, 36c, 36d, 36e, 36f, 46a, 46b, 46c, 46d) can be operated in the mechanical mode of operation to a second position in which the condenser heat exchanger (14, 34a, 34b, 34c, 44a, 44b) and the at least one economizer heat exchanger (24, 36a, 36b, 36c, 36d, 36e, 36f, 46a, 46b, 46c, 46d) can be operated in the economization mode of operation or the mixed mode of operation.

7. The outdoor cooling unit of claim 6, wherein the controller (28, 48), when sending the output signal, is configured to rotate the at least one economizer heat exchanger (24, 36a, 36b, 36c, 36d, 36e, 36f, 46a, 46b, 46c, 46d) to a first position in response to the input signal indicating the ambient temperature is above a predetermined temperature and configured to rotate the at least one economizer heat exchanger (24, 36a, 36b, 36c, 36d, 36e, 36f, 46a, 46b, 46c, 46d) to a second position in response to the input signal indicating the ambient temperature is below the predetermined temperature.

8. The outdoor cooling unit of claim 6 or claim 7, further comprising a linkage arm (50a, 50b, 50c, 50d) coupled to the at least one economizer heat exchanger (46a, 46b, 46c, 46d) and a piston (52a, 52b, 52c) configured to move the linkage arm (50a, 50b, 50c, 50d) and the at least one economizer heat exchanger (46a, 46b, 46c, 46d) between the first position and the second position.

9. The outdoor cooling unit of claim 8, wherein the piston (52a, 52b, 52c) is configured to move from a retracted position in which the at least one economizer heat exchanger (46a, 46b, 46c, 46d) is in the first position to an extended position in which the at least one economizer heat exchanger (46a, 46b, 46c, 46d) is in the second position.

10. The outdoor cooling unit of any of the claims 1 to 9, wherein the at least one economizer heat exchanger (46a, 46b, 46c, 46d) includes a first economizer heat exchanger (46a, 46c) and a second economizer heat exchanger (46b, 46d), and wherein the controller (48) further is configured to rotate the first economizer heat exchanger (46a, 46c) and the second economizer heat exchanger (46b, 46d).

11. The outdoor cooling unit of claim 10 in combination with claim 6, wherein the controller (48) is configured to rotate each of the first economizer heat exchanger (46a, 46c) and the second economizer heat exchanger (46b, 46d) from a first position in which the condenser heat exchanger (44a, 44b), the first economizer heat exchanger (46a, 46c) and the second economizer heat exchanger (46b, 46d) can be operated in the mechanical mode of operation to a second position in which the condenser heat exchanger (44a, 44b), the first economizer heat exchanger (46a, 46c) and the second economizer heat exchanger (46b, 46d) can be operated in the economization mode of operation or the mixed mode of operation.

12. The outdoor cooling unit of any of the claims 1 to 11, wherein the condenser heat exchanger (34a, 34b, 34c, 44a, 44b) is V-shaped.

13. A method (100) of operating an outdoor cooling unit of any of the claims 1 to 11, the method (100) comprising:
detecting (102) an ambient temperature;
receiving (104) an input signal indicating the ambient temperature; and
sending an output signal to rotate the at least one economizer heat exchanger in response to receiving the input signal.

14. A method (100) of operating an outdoor cooling unit of claim 13, the method (100) comprising:
in the event the ambient temperature is above a predetermined temperature, rotating (108) the economizer heat exchanger to a first position; and
in the event the ambient temperature is below the predetermined temperature, rotating (110) the economizer heat exchanger to a second position.

15. A non-transitory computer-readable medium storing thereon sequences of computer-executable instructions for controlling an operation of an outdoor cooling unit of any of the claims 1 to 12, the sequences of computer-executable instructions including instructions that instruct at least one processor to implement the method of claims 13 or 14:
